(19) **Europäisches Patentamt**
**European Patent Office**
**Office européen des brevets**

(11) **EP 2 425 308 B1**

(12) **EUROPÄISCHE PATENTSCHRIFT**

(45) Veröffentlichungstag und Bekanntmachung des Hinweises auf die Patenterteilung:
**15.06.2016 Patentblatt 2016/24**

(21) Anmeldenummer: **10717620.8**

(22) Anmeldetag: **28.04.2010**

(51) Int Cl.:
*G05B 23/02* (2006.01)    *B64C 13/00* (2006.01)

(86) Internationale Anmeldenummer:
**PCT/EP2010/055664**

(87) Internationale Veröffentlichungsnummer:
**WO 2010/125080 (04.11.2010 Gazette 2010/44)**

(54) **EINRICHTUNG UND VERFAHREN ZUR RESIDUENAUSWERTUNG EINES RESIDUUMS ZUR ERKENNUNG VON SYSTEMFEHLERN IM SYSTEMVERHALTEN EINES SYSTEMS EINES FLUGZEUGS**

DEVICE AND METHOD FOR THE RESIDUAL ANALYSIS OF A RESIDUUM TO DETECT SYSTEM ERRORS IN THE SYSTEM BEHAVIOR OF AN AIRCRAFT

DISPOSITIF ET PROCÉDÉ POUR ANALYSER UN RÉSIDU AFIN DE DÉTECTER DES ERREURS DE COMPORTEMENT DANS UN SYSTÈME D'AVION

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **28.04.2009  DE 102009002682**
**28.04.2009  US 173239 P**

(43) Veröffentlichungstag der Anmeldung:
**07.03.2012  Patentblatt 2012/10**

(60) Teilanmeldung:
**12191846.0 / 2 557 467**

(73) Patentinhaber: **Airbus Operations GmbH**
**21129 Hamburg (DE)**

(72) Erfinder:
 • **GOJNY, Marcus**
  **31700 Beauzelle Haute-Garonne (FR)**
 • **CARL, Udo, B.**
  **21077 Hamburg (DE)**
 • **SACHS, Helge**
  **22159 Hamburg (DE)**

(74) Vertreter: **Isarpatent**
**Patent- und Rechtsanwälte Behnisch Barth Charles**
**Hassa Peckmann & Partner mbB**
**Postfach 44 01 51**
**80750 München (DE)**

(56) Entgegenhaltungen:
EP-A2- 1 420 153    EP-A2- 2 026 158
US-A- 5 319 296     US-A1- 2007 124 038

• R.PONS, C.JAUBERTHIE, L.TRAVE-MASSUYES, P.GOUPIL: "Interval Analysis based learning for fault model identification; Application to control surfaces oscillatory failures" ASSOCIATION FOR THE ADVANCEMENT OF ARTIFICIAL INTELLIGENCE WWW.AAAI.ORG 19. Mai 2008 (2008-05-19), XP002606940 Gefunden im Internet: URL:http://www.cs.colorado.edu/~lizb/qr08/papers/Pons.pdf [gefunden am 2010-10-25]
• PHILIPPE GOUPIL: "Oscillatory Failure Case detection in the A380 electrical flight control system by analytical redundancy" CONTROL ENGINEERING PRACTICE 18 (2010) 23. Mai 2009 (2009-05-23), Seiten 1110-1119, XP002606933 Gefunden im Internet: URL:http://www.sciencedirect.com/ [gefunden am 2010-10-25]
• L.LAVIGNE, A.ZOLGHADRI, P.GOUPIL, P.SIMON: "Oscillatory Failure Case detection for new generation Airbus aircraft: a mode-based challenge" PROCEEDINGS OF THE 47TH IEEE CONFERENCE ON DECISION AND CONTROL 11. Dezember 2008 (2008-12-11), XP002606937 Gefunden im Internet: URL:http://ieeexplore.ieee.org/stamp/stamp .jsp?tp=&arnumber=4738621 [gefunden am 2010-10-25]

**Beschreibung**

Die vorliegende Erfindung betrifft eine Einrichtung und ein Verfahren zur Generierung eines Residuums zur Erkennung von fehlerhaften Transienten, Drift oder Oszillationen im Systemverhalten eines Systems eines Flugzeugs.

Das technische Gebiet der Erfindung betrifft die Auswertung eines generierten Residuums zur Erkennung von Systemfehlern, insbesondere von fehlerhaften Transienten, Drift oder Oszillationen, im Systemverhalten eines Systems eines Flugzeuges, beispielsweise eines elektrohydraulischen Ruderstellsystems.

Überschreitet das generierte Residuum eine vorbestimmte Schwelle oder Schranke, so ist ein Fehler im Systemverhalten detektiert. Solche Systemfehler im Systemverhalten zeigen sich in Form von fehlerhaften Transienten, Drift oder Oszillationen im Eingangs-/Ausgangsverhalten des Systems.

Dabei zieht die zunehmende Komplexität von Flugzeugsteuerungssystemen, insbesondere digitale Flugzeugsteuerungssysteme, die bei größtmöglicher Redundanz vor allem verbesserte Flugeigenschaften sowie eine Vielzahl an Sicherungsfunktionen und Komfortfunktionen ermöglichen, das vermehrte Auftreten zum Teil neuer Fehlerszenarien nach sich. Dazu zählen insbesondere nahezu ungedämpfte Stellflächenoszillationen der Stellflächen. Von besonderer Bedeutung sind dabei die OFC-Ursachen (OFC, Oscillatory Failure Case), welche durch Fehler im Stellsystem selbst auftreten oder sich aus den Flugsteuerungsrechnern oder der zur Erfassung der flugmechanischen Eigenbewegung vorgelagerten Sensorik in die Aktuatorregelkreise der jeweiligen Stellsysteme fortpflanzen.

Die Vielzahl der denkbaren OFC-Szenarien umfasst dabei Fehler in Komponenten der Datenverarbeitung und der Signalverarbeitung, Softwarefehler, mechanische Defekte, beispielsweise in der Servoventilbaugruppe, oder Ausfälle von elektronischen Einzelbausteinen auf unterster Schaltkreisebene, zum Beispiel im Spannungs-Strom-Wandler.

Weitere Fehlerszenarien können sich aus Wechselwirkungen zwischen den einzelnen Systemkomponenten des Aktuatorregelkreises oder des digitalen Flugsteuerungssystems ergeben.

Zur Detektion von solchen Systemfehlern ist im Rahmen eines modellbasierten Diagnoseansatzes die Generierung des Residuums zur Identifikation einer fehlerbedingten Abweichung des Realsystemverhaltens vom nominalen, fehlerfreien Systemverhalten erforderlich. Dazu zeigt die Druckschrift US 2007/0124038 A1 eine Lösung mittels einer Anwendung eines Parallelmodells zur Schätzung einer Kolbenposition des Ruderstellsystems des Flugzeuges, welche über eine kinematische Beziehung der Position der Stellfläche entspricht.

Zur Schätzung der Kolbenposition des realen, elektrohydraulischen Ruderstellsystems ist der Ansatz eines detaillierten, nicht linearen oder eines vereinfachten linearen Parallelmodells vorgesehen, welcher in der Fig. 2 der US 2007/0124038 A1 abgebildet ist. Dabei zeigt die mit dem Bezugszeichen 19 der Fig. 2 versehene Einheit das Parallelmodell, welches die detaillierte, nichtlineare Abbildung der realen Systemdynamik oder eine vereinfachte lineare Beschreibung beinhaltet. Als einziges Eingangssignal für das Parallelmodell 19 ist die zeitlich veränderliche Führungsvorgabe - bezeichnet mit dem Bezugszeichen 20 - für den Aktuatorregelkreis vorgesehen, welche vom Flugsteuerungsrechner eingeprägt wird. Das einzige Ausgangssignal des Parallelmodells 19 ist mit dem Bezugszeichen 29 bezeichnet und beschreibt die geschätzte zeitlich veränderliche Aktuatorkolbenposition.

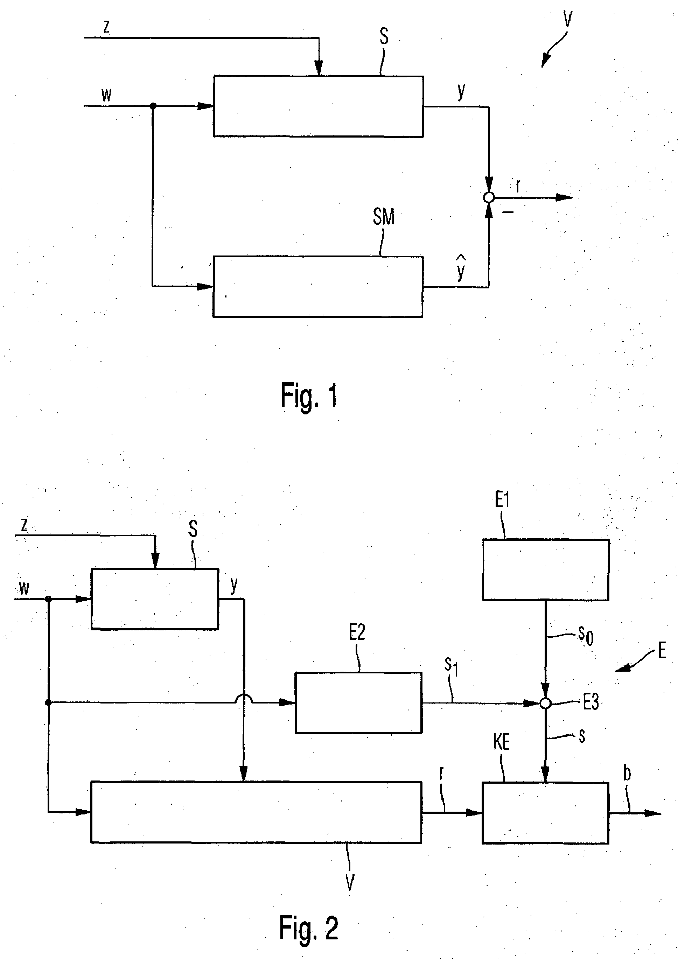

In diesem Zusammenhang zeigt die Fig. 1 der vorliegenden Anmeldung ein schematisches Blockschaltbild einer herkömmlichen Vorrichtung V zur Generierung eines Residuums r.

Dabei entspricht die herkömmliche Vorrichtung V nach Fig. 1 einer verallgemeinerten Darstellung der Fig. 4 der US 2007/0124038 A1, um die auftretenden Nachteile des Standes der Technik besser darstellen zu können.

Mit Bezug auf Fig. 1 bezeichnet das Bezugszeichen z eine Störgröße, die externe Störungen auf das System S abbildet.

Das System S hat als Eingangsgröße die Führungsgröße w und stellt ausgangsseitig die System-Ausgangsgröße y bereit. Das System S ist beispielsweise ein reales elektrohydraulisches Ruderstellsystem und die System-Ausgangsgröße y entspricht einer gemessenen Verschiebung des Aktuatorkolbens des Ruderstellsystems. Zur Bereitstellung einer geschätzten System-Ausgangsgröße $\hat{y}$ ist parallel zu dem System S ein Systemmodell SM angeordnet.

Der Kern des in der US 2007/0124038 A1 beschriebenen Schätzverfahrens besteht im Wesentlichen aus dem parallelen Systemmodell oder Prozessmodell, welches in Form einer mathematischen Beschreibung die Anfangswerte des Prozesses oder Systems und seine Parametrisierung bestmöglich approximiert. Das identische Eingangssignal für das System S, die Führungsgröße oder Führungsvorgabe w, ist das einzige Eingangssignals des Systemmodells SM. Gemäß der gewählten Anfangswerte und der parametrisierten Systemdynamik des definierten Systemmodells ergibt sich die geschätzte System-Ausgangsgröße $\hat{y}$ des Systemmodells SM. Zur Generierung des Residuums r wird die Differenz zwischen dem zeitlich veränderlichen Systemausgangssignal y und dem geschätzten Systemausgangssignal $\hat{y}$ des Systemmodells SM gebildet. Das Residuum r wird im Fall eines Überschreitens eines vordefinierten Schwellwertes zur Identifikation eines Systemfehlers verwendet.

Bei der Anwendung der in Fig. 1 skizzierten und aus der US 2007/0124038 A1 bekannten Lösung auf die spezifische Aufgabe der Erkennung von fehlerhaften Oszillationen, Drift und Transienten eines elektrohydraulischen Ruderstellsystems können folgende Probleme auftreten: Die Einstellung eines robusten und dennoch hochempfindlichen Detektionsschwellwertes für das Residuum r gelingt nicht ausreichend, da externe Störungen - bezeichnet mit dem Bezugszeichen z - auftreten können, die auf das System S wirken, aber vom Systemmodell SM nicht abgebildet werden. Diese externen Störungen ergeben sich bei einem elektrohydraulischen Ruderstellsystem insbesondere aus Luftkräften, die auf die angetriebene Stellfläche während des Fluges wirken und das Stellsystem mechanisch belasten, zum Bespiel durch transiente Strömungen durch einmalige Ereignisse wie Böen, harmonische Störungen durch periodische Wirbelablösungen oder Effekte aus der Flexibilität der umgebenden Struktur oder stochastische Störungen, insbesondere als Prozessrauschen aufgrund der aerodynamischen Wirkung von Turbulenzen. Ein weiterer Grund für die unzureichende Möglichkeit der Einstellung des Detektionsschwellwertes liegt in der permanenten Überlagerung der gemessenen Aktuatorposition als System-Ausgangsgröße y mit Messrauschen aufgrund der instrumentierten Sensorausstattung, beispielsweise der Positionsaufnehmer an der Aktuatorkolbenstange.

Weiter haben hochdynamische Veränderungen der Führungsgröße w unter Anwesenheit von Störungen ein sehr rasches, kurzfristiges Anwachsen des Residuums r zur Folge.

Des Weiteren verändert sich der Prozess oder das System S durch Änderungen von Parametern oder Randbedingungen, beispielsweise Fluggeschwindigkeit, Flughöhe, Anstell- und Schiebewinkel, Temperatur, Eigenschaften des hydraulischen Mediums des Aktuators und dergleichen, während des Betriebes oder Fluges. Diese Veränderungen wirken auf das Antwortverhalten des Systems S und damit auf die Eigendynamik des Systems S. Sie werden vom parallelen Prozessmodell oder Systemmodell SM nicht abgebildet.

Weiterhin können die Anfangswerte des Prozesses oder Systems S in praktischen Anwendungen lediglich durch ein Modell approximiert werden. Derart initiierte Abweichungen in der Systemantwort des Systemmodells SM sowie die Wirkung vernachlässigter und unbekannter Dynamik bleiben bei der aus der US 2007/0124038 A1 bekannten Lösung unkorrigiert.

Dies führt nachteiligerweise zu einem Signalanteil im Residuum, welcher eine sehr empfindliche Einstellung des Schwellwertes zur Fehlerdetektion ohne Einschränkung des überwachten Frequenzbandes ohne zusätzliche Maßnahmen erheblich erschwert.

In der US 2007/0124038 A1 (Fig. 2) ist zur Residuengenerierung durch Bildung des Differenzwertes zwischen den zeitveränderlichen Größen der gemessenen Aktuatorkolbenposition 22 und der Ausgangsgröße 29 des Parallelmodells der Subtrahierer 21 vorgesehen. Dessen Ausgangssignal 24 entspricht dem gebildeten Residuum. Weiter zeigt die mit Bezugszeichen 23 versehene Einheit ein Auswertemodul zur Auswertung des Residuums zur Fehlerdetektion.

Das Auswertemodul 23 vergleicht das Residuum 24 mit einem vordefinierten Schwellwert und zählt jede Überschreitung dieses Schwellwertes. Nach einer vorbestimmten Anzahl von gezählten Überschreitungen des vorbestimmten Schwellwertes wird ein oszillatorischer Fehlerfall festgestellt und ein Ausgangssignal 26 wird auf einen positiven logischen Wert zur Anzeige dieses Fehlers gesetzt.

Um eine gewisse Güte des Auswertemoduls 23 zu erreichen, besteht dieses aus einer seriellen Verknüpfung einer frequenzselektiven Filterbank, Einheit mit dem Bezugszeichen 27, und einer nachgeschalteten Komparatorstufe, Einheit mit dem Bezugszeichen 25, für jedes einzelne Frequenzband des Residuums 24. Die frequenzselektive Filterbank 27 besteht aus einer Parallelschaltung von Bandpassfiltern zur spektralen Trennung des Residuums 24 in vorbestimmte Frequenzbänder. Dabei bezeichnet das Bezugszeichen 28 einen Vektor der spektralen Anteile des Residuums 24 in den durch die frequenzselektive Filterbank 27 festgelegten Frequenzbändern.

Dazu umfasst die Komparatorbank 25 jeweils einen gesonderten Kanal für jede Komponente des Vektors 28, in welchem die jeweilige Komponente mit einem vordefinierten Schwellwert verglichen wird. In jedem Kanal wird der Fall der Überschreitung mittels eines Zählers vermerkt. Übersteigt die Anzahl der gezählten Überschreitungen eines Kanals eine vorab bestimmte Schranke, wird der oszillatorische Fehlerfall festgestellt und mittels des Ausgangssignals 28 angezeigt.

Bei der Anwendung dieser aus der US 2007/0124038 A1 bekannten Lösung auf die spezifische Aufgabe der Erkennung von Systemfehlern eines elektrohydraulischen Ruderstellsystems eines Flugzeuges können folgende Probleme auftreten: Die Einstellung eines robusten und dennoch hochempfindlichen Detektionsschwellwertes für das Residuum gelingt nicht ausreichend, und somit wird lediglich eine beschränkte Güte für die Überwachungsfunktion des Ruderstellsystems erreicht. Ein Grund hierfür ist unter anderem, dass hochdynamische Veränderungen der Führungsgröße oder Führungsvorgabe unter Anwesenheit von Störungen stets ein sehr rasches und kurzfristiges Anwachsen des Residuums bedingen. Diese können insbesondere durch den Betrieb in turbulenter Atmosphäre, durch Antwortverhalten flexibler Strukturen oder periodische Wirbelablösungen entstehen. Des Weiteren kann inhärentes Messrauschen des Systems diese nachteiligen Effekte zusätzlich verstärken. Um in den jeweiligen zugeordneten Frequenzbändern keine fortwährenden Fehlalarme auszulösen, müssen die Detektionsschwellenwerte entsprechend angehoben werden, und gegebenenfalls muss die Anzahl der erforderlichen Bestätigungszyklen erhöht werden. Dies hat für die Erkennung von Dauerschwingungen infolge von Systemfehlern eine stark verringerte Empfindlichkeit und weiter eine gesteigerte Erkennungszeit des Auswertemoduls zur Folge. Dies trifft insbesondere auf solche Systemfehler zu, bei denen sich ein oszillierender Anteil mit einem nominalen Systemausgangssignal niedriger Frequenz überlagert.

Ein weiterer Grund für die beschränkte Güte für die Überwachungsfunktion des Ruderstellsystems liegt im Übersprechen zwischen benachbarten Frequenzbereichen, da eine exakte Trennung technisch schwer realisierbar ist. Ein solches Übersprechen kann im Falle unterschiedlicher Schwellwerte vermehrt Fehlalarme auslösen.

Des Weiteren kann sich insbesondere aus dem strukturdynamischen Antwortverhalten eine Unsicherheit für die Festlegung der Grenzen der höheren Frequenzbänder in Kombination mit korrespondierenden festen Schwellwerten ergeben. Dies hat einen unmittelbaren nachteiligen Einfluss auf die zu erzielende Güte bei der Fehlererkennung im höheren Frequenzbereich. Durch die Anwendung der aus der US 2007/0124038 A1 bekannten Zählmethode ist die Fehlererkennung auf die Erkennung oszillatorischer Stellsystemfehler beschränkt. Die Möglichkeit einer Erweiterung auf andere Fehlerszenarien, wie Transienten oder Kriechen, sind methodisch grundsätzlich ausgeschlossen. Dieses macht für Monitorkonzepte moderner Stellsysteme nachteiligerweise eine parallele Aufstellung und Instrumentierung verschiedener spezifischer Einrichtungen zur Fehlererkennung erforderlich. Insgesamt erschwert die in der US 2007/0124038 A1 vorgeschlagene Anordnung zur Residuenauswertung eine empfindliche Einstellung des Schwellwertes zur breitbandigen Fehlerdetektion ohne Einschränkung des, überwachten Frequenzbandes erheblich.

Die EP 1 420 153 A2 offenbart eine weitere Vorrichtung und ein weiteres Verfahren zur Residuengenerierung zur Erkennung von Systemfehlern.

Demnach ist es eine Aufgabe der vorliegenden Erfindung, eine Residuengenerierung zur Erkennung von Systemfehlern, insbesondere von fehlerhaften Transienten, Drift oder Oszillationen, im Systemverhalten eines Systems eines Flugzeugs zu schaffen, welche die oben beschriebenen Nachteile nicht aufweist.

Erfindungsgemäß wird diese Aufgabe durch eine Einrichtung mit den Merkmalen des Patentanspruchs 1 und/oder ein Flugzeug mit den Merkmalen des Patentanspruchs 7 und/oder durch ein Verfahren mit den Merkmalen des Patentanspruchs 8 und/oder ein Computerprogrammprodukt mit den Merkmalen des Patentanspruchs 10 gelöst.

Demgemäß wird eine Vorrichtung zur Residuengenerierung zur Erkennung von fehlerhaften Transienten, Drift oder Oszillationen im Systemverhalten eines Systems eines Flugzeugs vorgeschlagen, welches eine Führungsvorgabe und eine externe Störungen abbildende Störgröße eingangsseitig empfängt und ausgangsseitig eine System-Ausgangsgröße bereitstellt, wobei die Vorrichtung aufweist:

- ein erstes Mittel mit einem System-Modell zur Abbildung des zu überwachenden Systems, welches eingangsseitig die Führungsgröße, eine Beobachterrückführgröße und eine Störmodellgröße empfängt und abhängig davon ausgangsseitig eine geschätzte System-Ausgangsgröße bereitstellt;

- ein zweites Mittel zur Bildung eines Residuums aus der Differenz zwischen der System-Ausgangsgröße und der geschätzten System-Ausgangsgröße;

- ein drittes Mittel mit einer Beobachter-Rückführung, welche eingangsseitig das Residuum empfängt und abhängig davon ausgangsseitig die Beobachterrückführgröße zur dynamischen Korrektur des Systemmodells derart bereitstellt, dass die geschätzte System-Ausgangsgröße der System-Ausgangsgröße folgt; und

- ein viertes Mittel mit einem Störmodell, welches eingangsseitig das Residuum empfängt und abhängig davon ausgangsseitig die Störmodellgröße zur Abbildung der Wirkungen der externen Störungen auf das System-Modell bereitstellt.

Das jeweilige Mittel, das erste bis vierte Mittel, kann hardwaretechnisch oder auch softwaretechnisch implementiert sein. Bei einer hardwaretechnischen Implementierung kann das jeweilige Mittel als Vorrichtung, zum Bespiel als Computer oder Mikroprozessor, Einrichtung oder auch als Teil eines Systems, zum Bespiel als Computer-System, ausgebildet sein. Bei einer softwaretechnischen Implementierung kann das jeweilige Mittel als Computerprogrammprodukt, als eine Funktion, als eine Routine, als Teil eines Programmcodes oder als ausführbares Objekt ausgebildet sein.

Des Weiteren wird ein Flugzeug mit zumindest einer wie oben beschriebenen Vorrichtung vorgeschlagen.

Weiterhin wird ein Verfahren zur Generierung eines Residuums (r) zur Erkennung von fehlerhaften Transienten, Drift oder Oszillationen im Systemverhalten eines Systems eines Flugzeugs vorgeschlagen. Das System empfängt eingangsseitig eine Führungsvorgabe und eine externe Störungen abbildende Störgröße und stellt ausgangsseitig eine System-Ausgangsgröße bereit. Das erfindungsgemäße Verfahren hat folgende Schritte:

- Bereitstellen eines System-Modells zur Abbildung des zu überwachenden Systems, welches eingangsseitig die Führungsgröße, eine Beobachterrückführgröße und eine Störmodellgröße empfängt und abhängig davon ausgangsseitig eine geschätzte System-Ausgangsgröße bereitstellt;

- Bilden eines Residuums aus der Differenz zwischen der System-Ausgangsgröße und der geschätzten System-Ausgangsgröße;

- Bereitstellen einer Beobachter-Rückführung, welche eingangsseitig das Residuum empfängt und abhängig davon ausgangsseitig die Beobachterrückführgröße zur dynamischen Korrektur des Systemmodells derart bereitstellt, dass die geschätzte System-Ausgangsgröße der System-Ausgangsgröße folgt; und

- Bereitstellen eines Störmodells, welches eingangsseitig das Residuum empfängt und abhängig davon ausgangsseitig die Störmodellgröße zur Abbildung der Wirkungen der externen Störungen auf das System-Modell bereitstellt, wobei die Störmodellgröße (z) als eine dynamische Störmodellgröße (z) ausgebildet ist, welche mittels einer Linearkombination einer Einregel-Matrix (K), eines Integrators ( $\frac{1}{s}$ ) und einer Störgrößen-Matrix (F) gebildet ist, wobei die Einregel-Matrix (K) das Residuum (r) eingangsseitig empfängt und die Störgrößen-Matrix (F) die Störmodellgröße (z) ausgangsseitig bereitstellt.

Ferner wird ein Computerprogrammprodukt vorgeschlagen, welches auf einer programmgesteuerten Einrichtung die Durchführung eines wie oben beschriebenen Verfahrens zur Residuengenerierung zur Erkennung von fehlerhaften Transienten, Drift oder Oszillationen im Systemverhalten eines Systems eines Flugzeugs veranlasst.

Das erste bis vierte Mittel bilden insbesondere eine Störbeobachter-Einheit oder einen Störbeobachter.

Der erfindungsgemäße Störbeobachter erzwingt ein Folgeverhalten des Systemmodells in Bezug auf die geschätzte System-Ausgangsgröße, beispielhaft die Kolbenposition des Ruderstellsystems. Dieses wird durch die Rückführung des Residuums über die Beobachterrückführung auf die internen Zustände des Systemmodells erreicht. Um Störungen auf den realen Prozess oder das reale System, insbesondere durch dynamische Luftlasten und Messrauschen für das Systemmodell, zu approximieren, wird das Störmodell parallel zur Beobachterrückführung aufgestellt. Die angenäherte oder geschätzte Störwirkung, welche erfindungsgemäß als Störmodellgröße abgebildet ist, wird ebenfalls auf die internen Zustände des Systemmodells zurückgeführt. Somit wird neben dem Folgeverhalten zusätzlich eine mittelbare Wirkung der externen Störungen des Systems in der geschätzten System-Ausgangsgröße bzw. im Störbeobachterausgang abgebildet.

Ein Vorteil der vorliegenden Erfindung liegt in der robusten Generierung eines Residuums, mittels dem das Vorliegen eines Fehlers, insbesondere in Form von fehlerhaften Transienten, Drift, Kriechen oder Oszillationen bei einem System eines Flugzeuges detektierbar ist. Die Auswertung erfolgt dann durch Vergleich des Residuums mit einem vorbestimmten Schwellwert.

Eine Einstellung robuster und hochempfindlicher Detektionsschwellwerte für das Residuum ist über die erfindungsgemäße Lösung möglich und ist mittels Tests mit realen Ruderstellsystemen Hardware-In-The-Loop gezeigt, deren Ergebnisse in Sachs, Helge: "Fault Investigation and Robust Failure Detection of Oscillatory Aircraft Actuation Systems Using Analytical Redundancy", Hamburg, Hamburg University of Technology, Aircraft Systems Engineering M-7, PhD thesis, nachgewiesen sind.

Dabei werden externe Störungen, die auf den Prozess oder das System wirken, durch den erfindungsgemäßen Störbeobachter als Näherung abgebildet. Solche externe Störungen oder Prozessstörungen resultieren im Wesentlichen aus Luftkräften, die auf die angetriebene Stellfläche während des Betriebes wirken, insbesondere als transiente Störungen durch einmalige Ereignisse wie Böen, harmonische Störungen durch periodische Wirbelablösungen oder Effekte aus der Flexibilität der umgebenden Struktur oder aus stochastischen Störungen wie Turbulenzen, und führen erfindungsgemäß nicht zu einer signifikanten Wirkung auf das Residuum.

Des Weiteren hat eine permanente Überlagerung der gemessenen Aktuatorposition als System-Ausgangsgröße mit Messrauschen (beispielsweise ausgedrückt durch das Signalrauschverhältnis) der Positionsaufnehmer an der Aktuatorkolbenstange) keinen signifikanten Einfluss auf das generierte Residuum.

Wie oben bereits ausgeführt, verändert sich das System oder der Prozess durch Änderungen von Parametern oder Randbedingungen während des Betriebes. Beispiele für solche veränderlichen Parameter sind die Fluggeschwindigkeit, die Flughöhe, der Anstell- und Schiebewinkel, die Temperatur, die Eigenschaften des hydraulischen Mediums des Aktuators und dergleichen. Diese Veränderungen wirken auf das Antwortverhalten und die Eigendynamik des Systems. Sie werden vom erfindüngsgemäßen Störbeobachter über das erzwungene Folgeverhalten ebenfalls abgebildet und werden im Residuum damit nicht sichtbar.

Unterschiedliche Anfangswerte im System und im Systemmodell werden ebenfalls über die Beobachterrückführung minimiert. Somit haben sie keine weiteren Auswirkungen auf das erfindungsgemäß generierte Residuum.

Sind weitere Messgrößen des Systems verfügbar oder vorab sicher beschreibbar, kann das Systemmodell um diese Elemente reduziert werden. Die messbaren Größen werden als zusätzliche Eingangsgrößen dem Störbeobachter bereitgestellt. Sie erhöhen vorteilhafterweise die Güte der geschätzten System-Ausgangsgröße des Störbeobachters und minimieren weiter das Residuum.

Sind Teile des Prozesses oder des Systems fest determiniert, werden diese aus dem Störbeobachter extrahiert. Der reduzierte Störbeobachter kann sich in diesem Fall auf den Teilprozess oder auf das Teilsystem der nicht unmittelbar messbaren und/oder sicheren dynamischen Effekte reduzieren. Die Reduktion des vollständigen Störbeobachters auf einen in die feststehenden Systemgleichungen integrierten, reduzierten Störbeobachter führt zu einer weiteren Steigerung der Robustheit und damit zur Beschleunigung der Laufzeiteigenschaften des vorgeschlagenen Verfahrens.

Die Erfindung wird im Folgenden anhand von Ausführungsbeispielen unter Bezugnahme auf die beiliegenden Figuren der Zeichnung näher erläutert.

Von den Figuren zeigen:

Fig. 1 ein schematisches Blockschaltbild eines Ausführungsbeispiels einer herkömmlichen Vorrichtung zur Residuengenerierung zur Erkennung von Systemfehlern eines Systems eines Flugzeugs;

Fig. 2 ein schematisches Blockschaltbild eines ersten Ausführungsbeispiels einer Einrichtung zur Residuenauswertung eines Residuums zur Erkennung von Systemfehlern im Systemverhalten eines Systems eines Flugzeugs;

Fig. 3 ein schematisches Blockschaltbild eines zweiten Ausführungsbeispiels einer Einrichtung zur Residuenauswertung eines Residuums zur Erkennung von Systemfehlern im Systemverhalten eines Systems eines Flugzeugs;

Fig. 4 ein schematisches Blockschaltbild eines ersten Ausführungsbeispiels einer Vorrichtung zur Residuengenerierung zur Erkennung von Systemfehlern im Systemverhalten eines Systems eines Flugzeugs;

Fig. 5 ein schematisches Blockschaltbild eines zweiten Ausführungsbeispiels einer Vorrichtung zur Residuengenerierung zur Erkennung von Systemfehlern im Systemverhalten eines Systems eines Flugzeugs;

Fig. 6 ein schematisches Ablaufdiagramm eines Ausführungsbeispiels eines Verfahrens zur Residuenauswertung eines Residuums zur Erkennung von Systemfehlern im Systemverhalten eines Systems eines Flugzeugs;

Fig. 7 ein schematisches Ablaufdiagramm eines Ausführungsbeispiels eines Verfahrens zur Residuengenerierung zur Erkennung von Systemfehlern im Systemverhalten eines Systems eines Flugzeugs; und

Fig. 8-12 schematische Zeitdiagramme zur Illustrierung der erfindungsgemäßen Residuenauswertung eines Residuums zur Erkennung von Systemfehlern im Systemverhalten eines Systems eines Flugzeuges.

In den Figuren bezeichnen dieselben Bezugszeichen gleiche oder funktionsgleiche Komponenten, soweit nichts Gegenteiliges angegeben ist.

Fig. 2 zeigt ein schematisches Blockschaltbild eines ersten Ausführungsbeispiels einer Einrichtung E zur Residuenauswertung eines Residuums r zur Erkennung von Systemfehlern im Systemverhalten eines Systems S eines Flugzeuges. Das System S empfängt eingangsseitig eine zeitlich veränderlich Führungsgröße w und eine externe Störungen abbildende Störgröße z. Abhängig davon stellt das System S ausgangsseitig eine System-Ausgangsgröße y bereit. Die Einrichtung E zur Residuenauswertung hat zumindest eine Vorrichtung V zur Residuengenerierung des Residuums r, eine Komparator-Einheit KE, eine erste Einheit E1, eine zweite Einheit E2 und eine dritte Einheit E3.

Die Vorrichtung V ist zur Residuengenerierung des Residuums r geeignet, wobei die Vorrichtung V das Residuum r zumindest in Abhängigkeit der Führungsgröße w und der System-Ausgangsgröße y generiert.

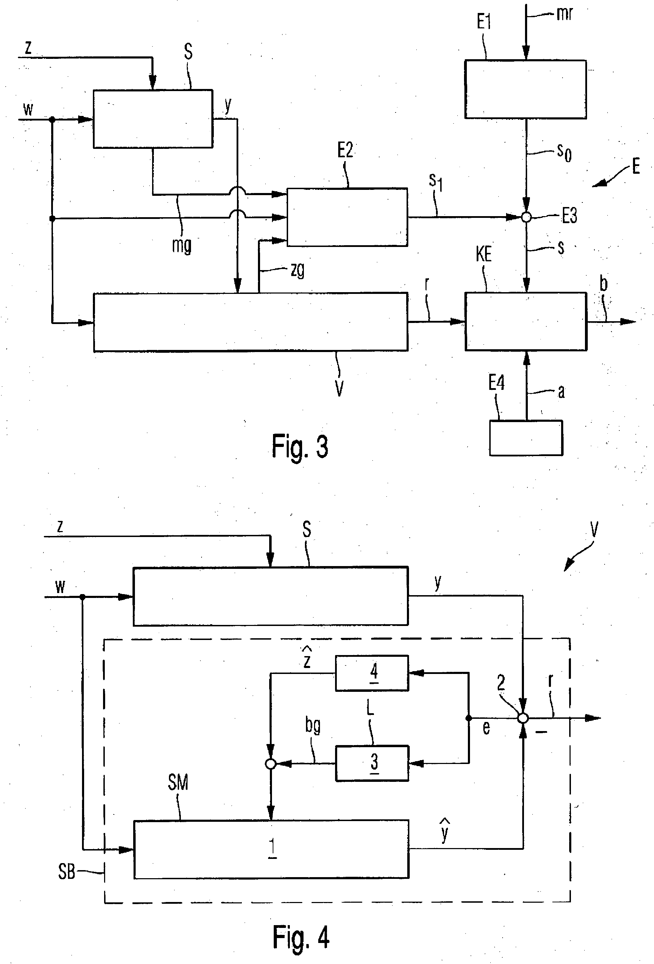

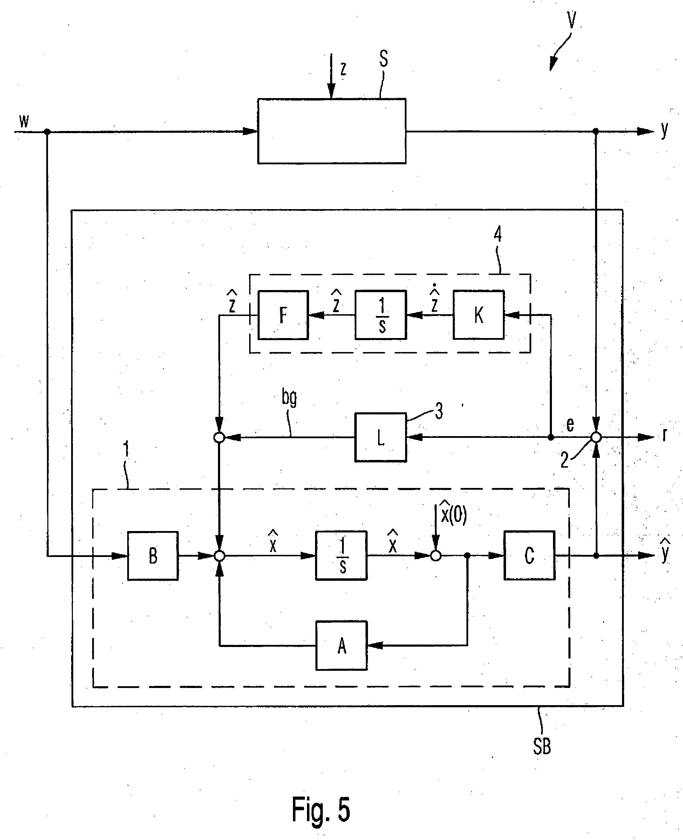

Die Vorrichtung V ist beispielsweise nach einem der Ausführungsbeispiele der Figuren 4 oder 5 ausgebildet.

Die Komparator-Einheit KE stellt ein Auswerte-Ergebnis b mittels eines Vergleichs des Residuums r mit einem bereitgestellten Schwellenwert s bereit.

Zur Bereitstellung des Schwellenwertes s sind die Einheiten E1 bis E3 vorgesehen.

Dabei ist die erste Einheit E1 dazu eingerichtet, einen konstanten Schwellwertanteil s0 bereitzustellen.

Die zweite Einheit E2 ist dazu eingerichtet, einen adaptiven Schwellwertanteil s1 zumindest in Abhängigkeit der zeitlich veränderlichen Führungsgröße w bereitzustellen.

Ferner ist die dritte Einheit E3 dazu eingerichtet, den Schwellwert s mittels einer Verknüpfung des konstanten Schwellwertanteils s0 mit dem adaptiven Schwellwertanteil s1 bereitzustellen. Insbesondere addiert die dritte Einheit E3 den konstanten Schwellwert S0 mit dem adaptiven Schwellwert s1 zur Ausbildung des Schwellwertes s.

Die Komparator-Einheit KE setzt das Auswerte-Ergebnis b zur Anzeige eines Systemfehlers auf einen positiven logischen Wert, falls das bereitgestellte Residuum r größer als der bereitgestellte Schwellwert s ist. Alternativ kann das Auswerte-Ergebnis b auch als ein Signal, beispielsweise als ein kontinuierliches Signal, ausgebildet sein, das dazu eingerichtet ist, die beiden möglichen Zustände ($r > s$ und $r \leq s$) anzuzeigen.

Fig. 3 zeigt ein zweites Ausführungsbeispiel einer erfindungsgemäßen Einrichtung E zur Residuenauswertung eines Residuums r zur Erkennung von Systemfehlern im Systemverhalten eines Systems S eines Flugzeuges.

Das zweite Ausführungsbeispiel gemäß Fig. 3 umfasst sämtliche Merkmale des ersten Ausführungsbeispiels gemäß Fig. 2, welche zur Vermeidung von Wiederholungen daher nicht erneut dargestellt werden.

Gemäß dem zweiten Ausführungsbeispiel der erfindungsgemäßen Einrichtung E ist die erste Einheit E1 dazu eingerichtet, den konstanten Schwellwertanteil s0 in Abhängigkeit eines zu erwartenden, inhärenten Messrauschens mr des Systems S bereitzustellen.

Dabei stellt die erste Einheit E1 den konstanten Schwellwert s0 vorzugsweise auf einen minimalen Wert.

Weiterhin ist gemäß Fig. 3 die zweite Einheit E2 dazu eingerichtet, den adaptiven Schwellwert s1 in Abhängigkeit der zeitveränderlichen Führungsgröße w, zumindest einer bereitgestellten Messgröße mg des Systems S und/oder einer mittels eines Systemmodells SM der Vorrichtung V geschätzten Zustandsgröße zg bereitzustellen.

Weiter weist die Einrichtung E vorzugsweise eine vierte Einheit E4 auf, welche dazu eingerichtet ist, die Komparator-Einheit KE nach Ablauf einer vorbestimmten Bestätigungszeit zu aktivieren. Hierzu steuert die vierte Einheit E4 die Komparator-Einheit KE vorzugsweise mittels eines Aktivierungssignals a.

Beispiele für die Vorrichtung V zur Residuengenerierung des Residuums r sind in den Figuren 4 und 5 dargestellt.

Dazu ist in Fig. 4 ein schematisches Blockschaltbild eines Ausführungsbeispiels der erfindungsgemäßen Vorrichtung V zur Residuengenerierung zur Erkennung von Systemfehlern, insbesondere von fehlerhaften Transienten, Drift oder Oszillationen, im Systemverhalten eines Systems S eines Flugzeugs dargestellt.

Die Vorrichtung V zur Residuengenerierung zur Erkennung von fehlerhaften Transienten, Drift oder Oszillationen im Systemverhalten eines Systems S eines Flugzeuges hat ein erstes Mittel 1, ein zweites Mittel 2, ein drittes Mittel 3 und ein viertes Mittel 4. Das erste bis vierte Mittel 1-4 bilden eine Störbeobachter-Einheit SB. Das System S empfängt eingangsseitig eine Führungsvorgabe w und eine Störgröße z, welche externe Störungen auf das System S abbildet. Abhängig davon stellt das System ausgangsseitig eine System-Ausgangsposition y bereit. Das System S ist beispielsweise ein elektrohydraulisches Ruderstellsystem des Flugzeuges, wobei dann die System-Ausgangsgröße y eine gemessene Verschiebung des Aktuatorkolbens des positionsgeregelten Ruderstellsystems S ist.

Das erste Mittel 1 hat ein System-Modell SM zur Abbildung des zu überwachenden Systems S. Das erste Mittel 1 empfängt eingangsseitig die Führungsgröße w, eine Beobachterrückführgröße b und eine Störmodellgröße $\hat{z}$. Abhängig davon stellt das erste Mittel 1 ausgangsseitig eine geschätzte System-Ausgangsgröße $\hat{y}$ bereit (Fig. 4).

Das zweite Mittel 2 ist dazu eingerichtet, ein Residuum r aus der Differenz zwischen der System-Ausgangsgröße y und der geschätzten System-Ausgangsgröße $\hat{y}$ zu bilden. Das zweite Mittel 2 ist beispielsweise als ein Subtrahierer ausgebildet.

Das dritte Mittel 3 ist als eine Beobachter-Rückführung L ausgebildet. Das dritte Mittel 3 empfängt eingangsseitig das Residuum r und stellt in Abhängigkeit des empfangenen Residuums r ausgangsseitig die Beobachterrückführgröße bg zur dynamischen Korrektur des Systemmodells SM derart bereit, dass die geschätzte System-Ausgangsgröße $\hat{y}$ der System-Ausgangsgröße y folgt.

Des Weiteren ist das vierte Mittel 4 mit einem Störmodell ZM ausgestattet, welches eingangsseitig das Residuum r empfängt und abhängig davon ausgangsseitig die Störmodellgröße $\hat{z}$ zur Abbildung der Wirkungen oder Effekte der externen Störungen auf das System-Modell SM bereitstellt.

Die Beobachterrückführung L ist insbesondere zur dynamischen Korrektur der inneren Zustände des System-Modells SM derart eingestellt, dass die geschätzte System-Ausgangsgröße $\hat{y}$ der System-Ausgangsgröße y folgt, wobei ein Abklingen einer Anfangsstörung und ein Folgeverhalten der externen Störungen durch eine Gewichtung der Residuen r und eine Rückführung auf das Systemmodell SM bereitgestellt wird.

Fig. 5 zeigt ein zweites Ausführungsbeispiel einer erfindungsgemäßen Vorrichtung V zur Residuengenerierung eines Residuums r zur Erkennung von Systemfehlern, insbesondere von fehlerhaften Transienten, Drift oder Oszillationen, im Systemverhalten eines Systems S eines Flugzeuges.

Das zweite Ausführungsbeispiel gemäß Fig. 5 umfasst sämtliche Merkmale des ersten Ausführungsbeispiels gemäß Fig. 4, welche zur Vermeidung von Wiederholungen daher nicht erneut dargestellt werden.

Gemäß dem zweiten Ausführungsbeispiel der erfindungsgemäßen Vorrichtung V hat die Störbeobachter-Einheit SB eine Beobachterrückführmatrix L zur Ausbildung der Beobachterrückführung. Dabei werden die Koeffizienten der Beobachterrückführmatrix L über einen Zustandsreglerentwurf bestimmt. Der Zustandsreglerentwurf ist beispielsweise durch eine Polvorgabe, durch einen optimalen Reglerentwurf, durch ein Entwurfsverfahren zum Entwurf robuster Rückführungen, durch lineare quadratische Schätzer (LQE; Linear Quadratic Estimator) oder durch nicht lineare Ansätze ausgebildet.

Ferner ist die Störmodellgröße $\hat{z}$ oder geschätzte Störgröße $\hat{z}$ als eine dynamische Störmodellgröße $\hat{z}$ ausgebildet, welche mittels einer Linearkombination künstlicher Systemzustände gebildet wird.

Dabei wird die dynamische Störmodellgröße $\hat{z}$ vorzugsweise mittels einer Linearkombination einer Einregel-Matrix K, eines Integrators $\frac{1}{s}$ und einer Störgrößenmatrix F gebildet. Dabei empfängt die Einregel-Matrix K das Residuum r und die Störgrößen-Matrix F stellt ausgangsseitig die Störmodellgröße $\hat{z}$ bereit. Der Integrator $\frac{1}{s}$ ist zwischen der Einregel-Matrix K und der Störgrößen-Matrix F angeordnet. In Analogie zum verallgemeinerten Zustandsvektor x des realen Systems S, bezeichnet $\hat{x}$ die Systemzustände des linearen Systemmodells SM, welche sich durch Integration mittels des Integrators $\frac{1}{s}$ aus zeitlichen Änderungen der Systemzustände $\dot{\hat{x}}$ ergeben. Diese sind die Summe der Störmodellausgangsgröße z, der Beobachterrückführgröße bg, einer über die Eingangsmatrix B gewichteten Führungsgröße w sowie der über die Systemmatrix A zurückgeführten Systemzustände $\hat{x}$. Eine Multiplikation der dynamischen Systemmodellzustände $\hat{x}$ mit der Ausgabematrix C ergibt die geschätzte System-Ausgangsgröße $\hat{y}$. $\hat{x}(0)$ beschreibt den Anfangswert des linearen Systemmodells SM.

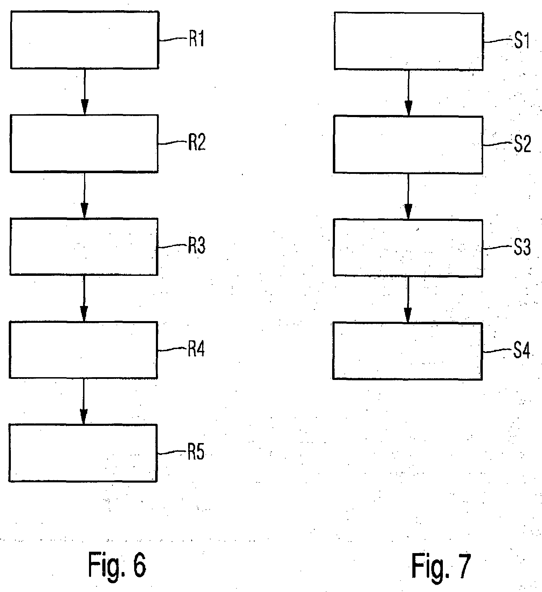

Fig. 6 zeigt ein schematisches Ablaufdiagramm eines Ausführungsbeispiels eines Verfahrens zur Residuenauswertung eines Residuums r zur Erkennung von Systemfehlern im Systemverhalten eines Systems S eines Flugzeugs.

Nachfolgend wird das erfindungsgemäße Verfahren anhand des Blockschaltbildes in Fig. 6 unter Verweis auf das Blockschaltbild in Fig. 2 beschrieben. Das Ausführungsbeispiel des erfindungsgemäßen Verfahrens gemäß Fig. 6 hat folgende Verfahrensschritte R1 bis R5:

Verfahrensschritt R1:

Ein Residuum r wird zumindest in Abhängigkeit der Führungsgröße w und der System-Ausgangsgröße y generiert.

Verfahrensschritt R2:

Ein konstanter Schwellwertanteil s0 wird bereitgestellt.

Verfahrensschritt R3:

Ein adaptiver Schwellwertanteil s1 wird zumindest in Abhängigkeit der zeitlich veränderlichen Führungsgröße w bereitgestellt.

Verfahrensschritt R4:

Ein Schwellwert s wird mittels einer Verknüpfung, insbesondere mittels einer Addition, des konstanten Schwellwertanteils s0 mit dem adaptiven Schwellwertanteil s1 bereitgestellt.

Verfahrensschritt R5:

Das Residuum r wird mit dem bereitgestellten Schwellwert s zur Bereitstellung eines Auswerte-Ergebnisses b verglichen. Liegt das Residuum r über dem bereitgestellten Schwellwert s, so ist ein Systemfehler des Systems S festgestellt.

Fig. 7 zeigt ein schematisches Ablaufdiagramm eines Ausführungsbeispiels des erfindungsgemäßen Verfahrens zur Residuengenerierung eines Residuums r zur Erkennung von Systemfehlern, insbesondere von fehlerhaften Transienten, Drift oder Oszillationen, im Systemverhalten eines Systems S eines Flugzeuges, welches eine Führungsgröße w und eine externe Störungen abbildende Störgröße z empfängt und ausgangsseitig eine System-Ausgangsgröße y bereitstellt.

Nachfolgend wird das erfindungsgemäße Verfahren anhand des Blockschaltbildes in Fig. 7 unter Verweis auf das Blockschaltbild in Fig. 4 beschrieben. Das Ausführungsbeispiel des erfindungsgemäßen Verfahrens gemäß Fig. 7 hat folgende Verfahrensschritte S1 bis S4:

Verfahrensschritt S1:

Ein Systemmodell SM zur Abbildung des zu überwachenden Systems S wird bereitgestellt. Das Systemmodell SM empfängt eingangsseitig die Führungsgröße w, eine Beobachterrückführgröße bg und eine Störmodellgröße z. Abhängig davon stellt das Systemmodell SM ausgangsseitig eine geschätzte System-Ausgangsgröße $\hat{y}$ bereit.

Verfahrensschritt S2:

Ein Residuum r wird aus der Differenz zwischen der System-Ausgangsgröße y und der geschätzten System-Ausgangsgröße $\hat{y}$ gebildet.

Verfahrensschritt S3:

Eine Beobachter-Rückführung L wird bereitgestellt, welche eingangsseitig das Residuum r empfängt und abhängig davon ausgangsseitig die Beobachterrückführgröße bg zur dynamischen Korrektur des Systemmodells SM derart bereitstellt, dass die geschätzte System-Ausgangsgröße $\hat{y}$ der System-Ausgangsgröße y folgt.

Verfahrensschritt S4:

Ein Störmodell ZM wird bereitgestellt, welches eingangsseitig das Residuum r empfängt und abhängig davon ausgangsseitig die Störmodellgröße $\hat{z}$ zur Abbildung der Wirkungen oder Effekte der externen Störungen auf das Systemmodell SM bereitstellt.

Vorzugsweise wird bei festgestellter Verfügbarkeit einer weiteren Messgröße des Systems S die Menge der geschätzten Systemgrößen im System-Modell SM um diese erweiterte Messgröße reduziert und diese weitere Messgröße wird dem System-Modell SM als weitere Eingangsgröße direkt zugeführt.

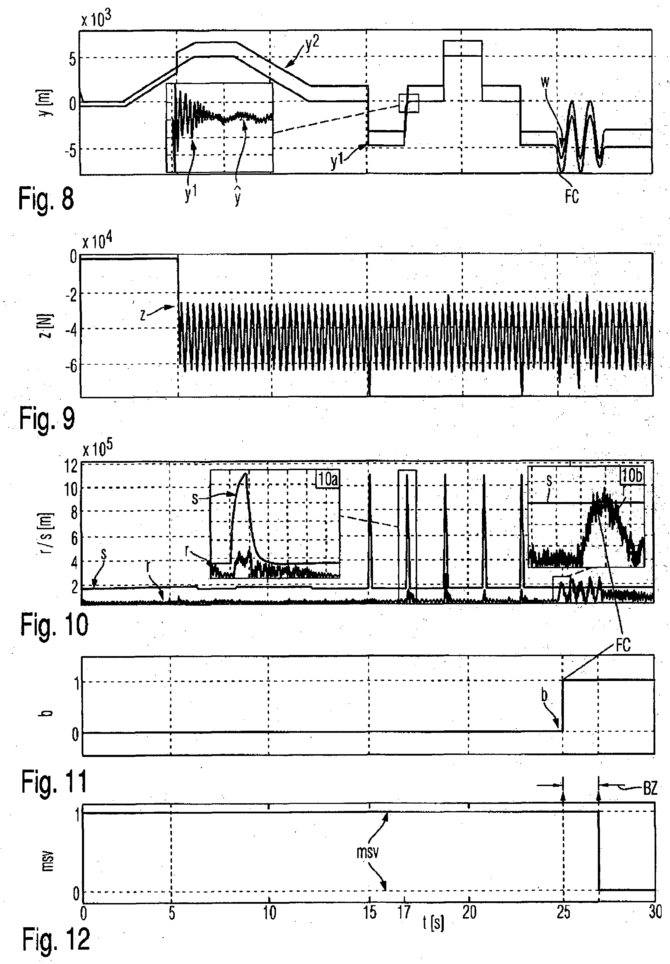

Die Figuren 8 bis 12 zeigen schematische Zeitdiagramme zur Illustrierung der erfindungsgemäßen Residuenauswertung eines Residuums r zur Erkennung von Systemfehlern FC im Systemverhalten eines Systems S eines Flugzeuges.

Dem Beispiel der Figuren 8 bis 12 liegt ein Ruderstellsystem als System S mit einem ersten Aktuator - bezeichnet durch die Verschiebung des Aktuatorkolbens des ersten Aktuators als das System-Ausgangssignal y1 - und einem redundanten zweiten Aktuator - bezeichnet durch die Verschiebung des Aktuatorkolbens des zweiten Aktuators als das System-Ausgangssignal y2-zugrunde.

Dabei zeigt Figur 8 den zeitlichen Verlauf der System-Ausgangssignale y1 und y2. Weiter zeigt Figur 9 den zeitlichen Verlauf der Störung z. Figur 10 zeigt den zeitlichen Verlauf des Residuums r und des erfindungsgemäßen Schwellwertes s. Weiter zeigen die Figuren 11 den zeitlichen Verlauf des Auswerte-Ergebnisses b sowie den zeitlichen Verlauf eines Ansteuersignals msv, das in Abhängigkeit des Auswerte-Ergebnisses b zur Auswahl des Aktuators 1 oder 2 generiert wird.

Wie oben bereits ausgeführt, zeigt Figur 8 den zeitlichen Verlauf der System-Ausgangssignale y1 und y2. Zum Zeitpunkt t = 17 s steigen die System-Ausgangssignale y1 und y2 gemäß der Führungsvorgabe w deutlich an.

Weiter zeigt Figur 9 den zeitlichen Verlauf der Störung z, die einer Kraft entspricht, mit der die durch den Aktuator 1 bzw. 2 angetriebene Stellfläche des Flugzeuges belastet wird. Diese Kraft wird auch als aerodynamische Last oder Luftlast bezeichnet.

Weiterhin zeigt Figur 10 den zeitlichen Verlauf des Residuums r und des erfindungsgemäßen Schwellwertes s. Dabei zeigt Figur 10a eine detaillierte Darstellung der Figur 10 um den Zeitpunkt t = 17 s, bei dem nach Figur 8 die Führungsgröße w und damit die System-Ausgangsgrößen y1 und y2 sprungartig ansteigen. Gemäß der Erfindung wird der Schwellwert s in Abhängigkeit der Führungsvorgabe w angepasst, d.h. der Schwellwert s wird in Abhängigkeit des Springens der Führungsvorgabe w angepasst und wird deshalb selbst springen (siehe Fig. 10a) Damit wird zum Zeitpunkt t = 17 s gemäß Figur 11 kein Fehler detektiert, so dass b = 0 zum Zeitpunkt t = 17 s ist.

Zum Zeitpunkt t = 25 s tritt hingegen ein Systemfehler FC auf, der in einem Schwingen der System-Ausgangssignale y1 und y2 resultiert. Nachdem sich zu diesem Zeitpunkt t = 25 s die Führungsvorgabe w nicht ändert, wird auch der Schwellwert s nicht angepasst. Folglich wird zum Zeitpunkt t = 25 s das Residuum r den bereitgestellten Schwellenwert s übersteigen. Dies ist im Detail in Figur 10b dargestellt.

Folglich wird hier gemäß Figur 11 das Auswerteergebnis b von 0 auf 1 umschalten, d.h. zum Zeitpunkt t = 25 s ist b = 1.

Gemäß Figur 12 wird nach Ablauf einer Bestätigungszeit BZ, die beispielsweise 2 s beträgt, ein Ansteuersignal msv von 1 auf 0 umschalten. Diese Umschaltung indiziert, dass von dem ersten Aktuator auf den zweiten Aktuator umgeschaltet wird. Damit ist zum Zeitpunkt t = 27 s die Rekonfiguration und damit die Umschaltung des Systems S von dem ersten Aktuator auf den zweiten Aktuator abgeschlossen.

Erfindungsgemäß kann die Bestätigungszeit auch auf 0 gesetzt werden, da bereits zum Zeitpunkt t = 25 s feststeht, dass eine Umschaltung von dem Aktuator 1 auf den Aktuator 2 notwendig ist.

Obwohl die vorliegende Erfindung anhand bevorzugter Ausführungsbeispiele vorliegend beschrieben wurde, ist sie darauf nicht beschränkt, sondern auf vielfältige Weise modifizierbar.

## Bezugszeichenliste

| | |
|---|---|
| 1 | erstes Mittel |
| 2 | zweites Mittel |
| 3 | drittes Mittel |
| 4 | viertes Mittel |
| a | Aktivierungssignal |
| BZ | Bestätigungszeit |
| b | Auswerte-Ergebnis |
| bg | Beobachterrückführgröße oder Ausgangssignal der Beobachterrückführung |
| A | Systemmatrix des linearen Systemmodells SM |
| B | Eingangsmatrix des linearen Systemmodells SM |
| C | Ausgabematrix des linearen Systemmodells SM |
| E1 | erste Einheit |
| E2 | zweite Einheit |
| E3 | dritte Einheit |
| E4 | vierte Einheit |
| F | Störgrößenmatrix |
| KE | Komparator-Einheit |
| K | Einregler-Matrix |
| L | Beobachterrückführmatrix |
| mg | Messgröße |
| mr | Messrauschen |
| R1-R5 | Verfahrensschritt |
| r | Residuum |
| S | System |
| S1-S4 | Verfahrensschritt |
| SB | Störbeobachter-Einheit |
| SM | System-Modell |
| FC | Systemfehler |
| w | Führungsgröße |
| y | System-Ausgangsgröße |
| $\hat{y}$ | geschätzte System-Ausgangsgröße |
| z | Störgröße |
| zg | Zustandsgröße |
| $\hat{z}$ | Störmodellgröße |
| ZM | Störmodell |
| $\frac{1}{s}$ | Integrator |

## Patentansprüche

**1.** Vorrichtung (V) zur Generierung eines Residuums (r) zur Erkennung von fehlerhaften Transienten, Drift oder Oszillationen im Systemverhalten eines Systems (S) eines Flugzeugs, welches eine Führungsvorgabe (w) und eine externe Störungen abbildende Störgröße (z) eingangsseitig empfängt und ausgangsseitig eine System-Ausgangsgröße (y) bereitstellt, mit:

   a) einem ersten Mittel (1) mit einem System-Modell (SM) zur Abbildung des zu überwachenden Systems (S), welches eingangsseitig die Führungsgröße (w), eine Beobachterrückführgröße (bg) und eine Störmodellgröße ($\hat{z}$) empfängt und abhängig davon ausgangsseitig eine geschätzte System-Ausgangsgröße ($\hat{y}$) bereitstellt;

b) einem zweiten Mittel (2) zur Bildung eines Residuums (r) aus der Differenz zwischen der System-Ausgangsgröße (y) und der geschätzten System-Ausgangsgröße (y);

c) einem dritten Mittel (3) mit einer Beobachter-Rückführung, welche eingangsseitig das Residuum (r) empfängt und abhängig davon ausgangsseitig die Beobachterrückführgröße (bg) zur dynamischen Korrektur des System-Modells (SM) derart bereitstellt, dass die geschätzte System-Ausgangsgröße ($\hat{y}$) der System-Ausgangsgröße (y) folgt; und

d) einem vierten Mittel (4) mit einem Störmodell (ZM), welches eingangsseitig das Residuum (r) empfängt und abhängig davon ausgangsseitig die Störmodellgröße ($\hat{z}$) zur Abbildung der Wirkungen der externen Störungen auf das Systemmodell (SM) bereitstellt, wobei die Störmodellgröße ($\hat{z}$) als eine dynamische Störmodellgröße ($\hat{z}$) ausgebildet ist, welche mittels einer Linearkombination einer Einregel-Matrix (K), eines Integrators ($\frac{1}{s}$) und einer Störgrößen-Matrix (F) gebildet ist, wobei die Einregel-Matrix (K) das Residuum (r) eingangsseitig empfängt und die Störgrößen-Matrix (F) die Störmodellgröße (z) ausgangsseitig bereitstellt.

2. Vorrichtung nach Anspruch 1,
**dadurch gekennzeichnet,**
**dass** das System (S) ein elektrohydraulisches Ruderstellsystem des Flugzeuges ist.

3. Vorrichtung nach Anspruch 2,
**dadurch gekennzeichnet,**
**dass** die System-Ausgangsgröße (y) eine gemessene Verschiebung des Aktuatorkolbens des positionsgeregelten Ruderstellsystems (S) oder die gemessene Stellflächenposition des Flugzeuges ist.

4. Vorrichtung nach einem der Ansprüche 1 bis 3,
**dadurch gekennzeichnet,**
**dass** die Beobachterrückführung zur dynamischen Korrektur der inneren Zustände des Systemmodells (SM) derart eingestellt ist, dass die geschätzte System-Ausgangsgröße (y) der System-Ausgangsgröße (y) folgt, wobei ein Abklingen einer Anfangsstörung und ein Folgeverhalten der externen Störungen durch eine Gewichtung der Residuen (r.) und eine Rückführung auf das Systemmodell'(SM) bereitgestellt wird.

5. Vorrichtung nach Anspruch 4,
**dadurch gekennzeichnet,**
**dass** die Beobachterrückführung eine Beobachterrückführmatrix (L) umfasst.

6. Vorrichtung nach Anspruch 5,
**dadurch gekennzeichnet,**
**dass** Koeffizienten der Beobachterrückführmatrix (L) über einen Zustandsreglerentwurf, insbesondere über Polvorgabe, Optimalreglerentwurf, Entwurfsverfahren zum Entwurf robuster Rückführungen, lineare quadratische Schätzer (LQE) oder nichtlineare Ansätze, bestimmt werden.

7. Flugzeug mit einer oder mehreren Vorrichtungen (V) nach einem der Ansprüche 1 bis 6.

8. Verfahren zur Generierung eines Residuums (r) zur Erkennung von fehlerhaften Transienten, Drift oder Oszillationen im Systemverhalten eines Systems (S) eines Flugzeuges, welches eine Führungsvorgabe (w) und eine externe Störungen abbildende Störgröße (z) eingangsseitig empfängt und ausgangsseitig eine System-Ausgangsgröße (y) bereitstellt, mit den Schritten:

a) Bereitstellen eines System-Modells (SM) zur Abbildung des zu überwachenden Systems (S), welches eingangsseitig die Führungsgröße (w), eine Beobachterrückführgröße (bg) und eine Störmodellgröße ($\hat{z}$) empfängt und abhängig davon ausgangsseitig eine geschätzte System-Ausgangsgröße ($\hat{y}$) bereitstellt;

b) Bilden eines Residuums (r) aus der Differenz zwischen der System-Ausgangsgröße (y) und der geschätzten System-Ausgangsgröße ($\hat{y}$);

c) Bereitstellen einer Beobachter-Rückführung, welche eingangsseitig das Residuum (r) empfängt und abhängig davon ausgangsseitig die Beobachterrückführgröße (bg) zur dynamischen Korrektur des Systemmodells (SM) derart bereitstellt, dass die geschätzte System-Ausgangsgröße ($\hat{y}$) der System-Ausgangsgröße (y) folgt; und

d) Bereitstellen eines Störmodells (ZM), welches eingangsseitig das Residuum (r) empfängt und abhängig davon ausgangsseitig die Störmodellgröße ($\hat{z}$) zur Abbildung der Wirkungen der externen Störungen auf das System-Modell (SM) bereitstellt, wobei die Störmodellgröße ($\hat{z}$) als eine dynamische Störmodellgröße ($\hat{z}$) ausgebildet ist, welche mittels einer Linearkombination einer Einregel-Matrix (K), eines Integrators ($\frac{1}{s}$) und einer Störgrößen-Matrix (F) gebildet ist, wobei die Einregel-Matrix (K) das Residuum (r) eingangsseitig empfängt und die Störgrößen-Matrix (F) die Störmodellgröße (z) ausgangsseitig bereitstellt.

9. Verfahren nach Anspruch 8,
**dadurch gekennzeichnet,**
**dass** bei Verfügbarkeit einer weiteren Messgröße des Systems (S) das System-Modell (SM) um diese weitere Messgröße reduziert wird und diese weitere Messgröße dem System-Modell (SM) als weitere Eingangsgröße zugeführt wird.

10. Computerprogrammprodukt, welches auf einer programmgesteuerten Einrichtung die Durchführung eines Verfahrens nach Anspruch 8 oder 9 veranlasst.

**Claims**

1. Apparatus (V) for generating a residuum (r) for detecting erroneous transients, drift or oscillations in the system behaviour of a system (S) of an aircraft, which system receives on the input-side a guide default (w) and a disturbance variable (z) which reproduces external disturbances, and provides on the output side a system output variable (y), comprising:

   a) a first means (1) comprising a system model (SM) for reproducing the system (S) to be monitored which receives on the input-side the guide variable (w), an observer feedback variable (bg) and a disturbance model variable (z), and as a function thereof provides on the output-side an estimated system output variable $(\hat{y})$;
   b) a second means (2) for forming a residuum (r) from the difference between the system output variable (y) and the estimated system output variable $(\hat{y})$;
   c) a third means (3) comprising an observer feedback, which receives on the input-side the residuum (r) and as a function thereof provides on the output-side the observer feedback variable (bg) for dynamic correction of the system model (SM) such that the estimated system output variable $(\hat{y})$ follows the system output variable (y); and
   d) a fourth means (4) comprising a disturbance model (ZM) which receives on the input-side the residuum (r) and as a function thereof provides on the output-side the disturbance model variable $(\hat{z})$ for reproducing the effects of the external disturbances on the system model (SM), wherein the disturbance model variable $(\hat{z})$ is formed as a dynamic disturbance model variable $(\hat{z})$ which is formed by means of a linear combination of a tuning matrix (K), an integrator $\left(\dfrac{1}{s}\right)$ and a disturbance variable matrix (F), wherein the tuning matrix (K) receives on the input-side the residuum (r) and the disturbance variable matrix (F) provides on the output-side the disturbance model variable (z).

2. Apparatus as claimed in claim 1,
**characterised in that**
the system (S) is an electrohydraulic rudder adjustment system of the aircraft.

3. Apparatus as claimed in claim 2,
**characterised in that**
the system output variable (y) is a measured displacement of the actuator piston of the position-controlled rudder adjustment system (S) or the measured control surface position of the aircraft.

4. Apparatus as claimed in any one of claims 1 to 3,
**characterised in that**
the observer feedback is set for dynamic correction of the internal states of the system model (SM) such that the estimated system output variable $(\hat{y})$ follows the system output variable (y), wherein a decay of an initial disturbance and a following behaviour of the external disturbances is provided by weighting of the residua (r) and feedback into the system model (SM).

5. Apparatus as claimed in claim 4,
**characterised in that**
the observer feedback comprises an observer feedback matrix (L).

6. Apparatus as claimed in claim 5,
**characterised in that**
coefficients of the observer feedback matrix (L) are determined via a state controller design, in particular via a pole default, an optimum controller design, design methods for designing robust feedbacks, linear quadratic estimators (LQEs) or non-linear approaches.

7. Aircraft comprising one or a plurality of apparatuses (V) as claimed in any one of claims 1 to 6.

8. Method for generating a residuum (r) for detecting erroneous transients, drift or oscillations in the system behaviour of a system (S) of an aircraft, which system receives on the input-side a guide default (w) and a disturbance variable (z), which reproduces external disturbances, and provides on the output-side a system output variable (y), having the steps of:

   a) providing a system model (SM) for reproducing the system (S) to be monitored, which receives on the input-side the guide variable (w), an observer feedback variable (bg) and a disturbance model variable $(\hat{z})$ and as a function thereof provides on the output-side an estimated

system output variable ($\hat{y}$);

b) forming a residuum (r) from the difference between the system output variable (y) and the estimated system output variable ($\hat{y}$);

c) providing an observer feedback which receives on the input-side the residuum (r) and as a function thereof provides on the output-side the observer feedback variable (bg) for dynamic correction of the system model (SM) such that the estimated system output variable ($\hat{y}$) follows the system output variable (y); and

d) providing a disturbance model (ZM) which receives on the input-side the residuum (r) and as a function thereof provides on the output-side the disturbance model variable ($\hat{z}$) for reproducing the effects of the external disturbances on the system model (SM), wherein the disturbance model variable ($\hat{z}$) is formed as a dynamic disturbance model variable ($\hat{z}$) which is formed by means of a linear combination of a tuning matrix (K), an integrator $\left(\dfrac{1}{s}\right)$ and a disturbance variable matrix (F), wherein the tuning matrix (K) receives on the input-side the residuum (r) and the disturbance variable matrix (F) provides on the output-side the disturbance model variable ($\hat{z}$).

9. Method as claimed in claim 8, **characterised in that**
   when a further measurement variable of the system (S) is available, the system model (SM) is reduced by this further measurement variable and this further measurement variable is supplied to the system model (SM) as a further input variable.

10. Computer program product which causes a method as claimed in claim 8 or 9 to be carried out on a program-controlled device.

**Revendications**

1. Dispositif (V) destiné à générer un résidu (r) permettant de détecter des transitoires défectueux, des dérives ou des oscillations dans le comportement de système d'un système (S) d'un aéronef, lequel système reçoit côté entrée une instruction de gestion (w) et une grandeur perturbatrice (z) reproduisant des perturbations externes, et fournit côté sortie une grandeur de sortie (y) du système, comprenant :

   a) un premier moyen (1) comprenant un modèle de système (SM) pour la reproduction du système (S) à surveiller, lequel reçoit côté entrée l'instruction de gestion (w), une grandeur de retour d'observateur (bg) et une grandeur de modèle

de perturbation ($\hat{z}$) et, en fonction de cela, fournit côté sortie une grandeur de sortie estimée ($\hat{y}$) du système ;

   b) un deuxième moyen (2) pour la formation d'un résidu (r) à partir de la différence entre la grandeur de sortie (y) du système et la grandeur de sortie estimée ($\hat{y}$) du système ;

   c) un troisième moyen (3) comprenant un retour d'observateur, lequel reçoit le résidu (r) côté entrée et, en fonction de cela, fournit côté sortie la grandeur de retour d'observateur (bg) pour la correction dynamique du modèle de système (SM) de manière à ce que la grandeur de sortie estimée ($\hat{y}$) du système succède à la grandeur de sortie du système (y) ; et

   d) un quatrième moyen (4) comprenant un modèle de perturbation (ZM), lequel reçoit le résidu (r) côté entrée et, en fonction de cela, fournit côté sortie la grandeur de modèle de perturbation ($\hat{z}$) pour la reproduction des effets des perturbations externes sur le modèle de système (SM), dans lequel la grandeur de modèle de perturbation ($\hat{z}$) est réalisée comme une grandeur de modèle de perturbation dynamique (z), laquelle est formée au moyen d'une combinaison linéaire d'une matrice de régulation (K), d'un intégrateur $\left(\dfrac{1}{s}\right)$ et d'une matrice de grandeur perturbatrice (F), dans lequel la matrice de régulation (K) reçoit le résidu (r) côté entrée et dans lequel la matrice de grandeur perturbatrice (F) fournit la grandeur de modèle de perturbation ($\hat{z}$) côté sortie.

2. Dispositif selon la revendication 1, **caractérisé en ce que** le système (S) est un système de réglage de gouverne électrohydraulique de l'aéronef.

3. Dispositif selon la revendication 2, **caractérisé en ce que** la grandeur de sortie du système (y) est un décalage mesuré du piston d'actionneur du système de régulation de gouverne (S) réglé en position ou la position mesurée du plan réglable de l'aéronef.

4. Dispositif selon l'une quelconque des revendications 1 à 3, **caractérisé en ce que** le retour d'observateur pour la correction dynamique des états intérieurs du modèle de système (SM) est réglé de manière à ce que la grandeur de sortie estimée ($\hat{y}$) du système succède à la grandeur de sortie du système (y), dans lequel un évanouissement d'une perturbation initiale et un comportement consécutif des perturbations externes sont fournis par une pondération des résidus (r) et un retour sur le modèle de système (SM).

**5.** Dispositif selon la revendication 4, **caractérisé en ce que** le retour d'observateur comprend une matrice de retour d'observateur (L).

**6.** Dispositif selon la revendication 5, **caractérisé en ce que** des coefficients de la matrice de retour d'observateur (L) sont déterminés par l'intermédiaire d'un projet de régleur d'état, notamment par l'intermédiaire d'une indication de pôle, d'un projet de régleur optimal, d'un procédé de projet pour la conception de retours robustes, d'évaluateurs linéaires carrés (LQE) ou d'approches non linéaires.

**7.** Aéronef comprenant un ou plusieurs dispositifs (V) selon l'une quelconque des revendications 1 à 6.

**8.** Procédé destiné à générer un résidu (r) permettant de détecter des transitoires défectueux, des dérives ou des oscillations dans le comportement de système d'un système (S) d'un aéronef, lequel système reçoit côté entrée une instruction de gestion (w) et une grandeur perturbatrice (z) reproduisant des perturbations externes, et fournit côté sortie une grandeur de sortie (y) du système, comprenant les étapes :

a) mise à disposition d'un modèle de système (SM) pour la reproduction du système (S) à surveiller, lequel reçoit côté entrée l'instruction de gestion (w), une grandeur de retour d'observateur (bg) et une grandeur de modèle de perturbation ($\hat{z}$) et, en fonction de cela, fournit côté sortie une grandeur de sortie estimée ($\hat{y}$) du système ;

b) formation d'un résidu (r) à partir de la différence entre la grandeur de sortie du système (y) et la grandeur de sortie estimée (($\hat{y}$) du système ;

c) mise à disposition d'un retour d'observateur, lequel reçoit le résidu (r) côté entrée et, en fonction de cela, fournit côté sortie la grandeur de retour d'observateur (bg) pour la correction dynamique du modèle de système (SM) de manière à ce que la grandeur de sortie estimée ($\hat{y}$) du système succède à la grandeur de sortie (y) du système ; et

d) mise à disposition d'un modèle de perturbation (ZM), lequel reçoit le résidu (r) côté entrée et, en fonction de cela, fournit côté sortie la grandeur de modèle de perturbation ($\hat{z}$) pour la reproduction des effets des perturbations externes sur le modèle de système (SM), dans lequel la grandeur de modèle de perturbation ($\hat{z}$) est réalisée comme une grandeur de modèle de perturbation dynamique (z), laquelle est formée au moyen d'une combinaison linéaire d'une matrice de régulation (K), d'un intégrateur $\left(\dfrac{1}{s}\right)$ et d'une matrice de grandeur perturbatrice (F), dans lequel la matrice de régulation (K) reçoit le résidu (r) côté entrée et dans lequel la matrice de grandeur perturbatrice (F) fournit la grandeur de modèle de perturbation ($\hat{z}$) côté sortie.

**9.** Procédé selon revendication 8, **caractérisé en ce que** lorsqu'une grandeur de mesure supplémentaire du système (S) est disponible, le modèle de système (SM) est diminué de cette grandeur de mesure supplémentaire et cette grandeur de mesure supplémentaire est amenée au modèle de système (SM) en tant que grandeur d'entrée supplémentaire.

**10.** Produit de programme informatique, lequel entraîne la réalisation d'un procédé selon la revendication 8 ou 9 sur un dispositif commandé par programme.

Fig. 1

Fig. 2

Fig. 3

Fig. 4

Fig. 5

R1

R2

R3

R4

R5

**Fig. 6**

S1

S2

S3

S4

**Fig. 7**

Fig. 8

Fig. 9

Fig. 10

Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20070124038 A1
- EP 1420153 A2